# EUROPEAN PATENT SPECIFICATION

(11) **EP 0 424 014 B1**
(45) Date of publication and mention of the grant of the patent: **15.07.1998**
(21) Application number: 90311082.3
(22) Date of filing: 10.10.1990
(51) Int. Cl.: H01L 29/737, H01L 29/70, H01L 31/11

(54) **Semiconductor circuit comprising a bistable, bipolar transistor**
Halbleiterschaltung mit einem bistabilen Bipolartransistor
Circuit semi-conducteur comprenant un transistor bipolaire bistable

(30) Priority: 18.10.1989 US 423076
(43) Date of publication of application: 24.04.1991
(73) Proprietor: AT&T Corp., New York, NY 10013-2412 (US)
(72) Inventor: Tsang, Won-Tien, Holmdel, New Jersey 07733 (US); Wu, Ming-Chiang, Bridgewater, New Jersey 08807 (US)
(74) Representative: Watts, Christopher Malcolm Kelway, Dr.

(56) References cited:
- APPLIED PHYSICS LETTERS. vol. 54, no. 9, 27 February 1989, NEW YORK US pages 813 - 815; K. BERTHOLD ET AL.: 'High-Field Transport in GaAs Transistors'
- SOLID STATE ELECTRONICS. vol. 31, no. 3/4, March 1988, OXFORD GB pages 723 - 729; F. CAPASSO ET AL.: 'Resonant Tunneling through Quantum Wells: Physics and Device Applications'
- APPLIED PHYSICS LETTERS. vol. 57, no. 2, 9 July 1990, NEW YORK US pages 150 - 152; M. C. WU ET AL.: 'Quantum-Switched Heterojunction Bistable Bipolar Transistor by Chemical Beam Epitaxy'
- APPLIED PHYSICS LETTERS. vol. 55, no. 17, 23 October 1989, NEW YORK US pages 1771 - 1773; M. C. WU ET AL.: 'Quantum-Switched Heterojunction Bipolar Transistor'

## Description

### Background of the Invention

### 1. Field of the Invention

The invention pertains to semiconductor circuits which include bistable, bipolar transistors.

### 2. Art Background

Bipolar transistors are considered attractive for use in a variety of electronic circuits because, among other reasons, such transistors are capable of operating at significantly higher speeds than, for example, field effect transistors. On the other hand, bipolar transistors have the drawback that, in use, they require continuous electrical power, leading to significant power dissipation problems.

Included among the circuits in which bipolar transistors are employed are, for example, high speed electronic logic circuits. Such a logic circuit necessarily includes at least two (conventional) bipolar transistors to achieve the two electrical states essential to conventional binary logic. In this regard, it has been recognized that if one could achieve a bistable bipolar transistor, i.e., a bipolar transistor capable of exhibiting either of two stable electrical states, then the number of bipolar transistors employed in logic circuits could be reduced by half, and therefore the cost of such circuits could be significantly reduced. Moreover, the power dissipation problems inherent in the use of the bipolar transistors would be correspondingly reduced.

A recent advance in the art of bipolar transistors has resulted in the development of what are now called resonant tunneling bipolar transistors (RTBTs). These new devices are significant because, among other reasons, and under appropriate circumstances, they exhibit two (or more) stable states. That is, an RTBT typically includes a heterojunction, and a corresponding potential barrier, at the emitter-base interface. An RTBT typically also includes at least one quantum well layer sandwiched between two potential barrier layers, within the base. See Capasso et al. in Solid-State Electronics, vol. 31, nos. 3/4, March/April 1988, pages 723-729. (RTBTs have also been proposed in which the quantum well and the two potential barrier layers are positioned intermediate the emitter and base.) Significantly, the presence of the quantum well results in the presence of one or more quantized, discrete energy states within the quantum well. In addition, as discussed below, the presence of these energy states permits one to achieve control over the flow of electrical current from the emitter to the collector by controlling the emission process.

Assuming the Fermi level, E_{F}, in the emitter of an RTBT is below the first energy state, E₁, in the quantum well, then increasing the base-emitter voltage, V_{BE}, reduces the energy difference between E_{F} and E₁. When the two levels are equal, electrons tunneling from the emitter are injected into the first energy state of the quantum well and undergo resonant tunneling (hence the name RTBT) through the two potential barriers with near unity transmission probability. A further increase in V_{BE} destroys the resonance, resulting in a transmission probability which is much less than one and equal to the product of the transmission coefficients of the two barriers without the quantum well. If the quantum well is also characterized by a second, higher, discrete energy state, E₂, then a further appropriate increase in V_{BE} will result in E_{F} being equal to E₂, i.e., will result in a second resonance condition. As a result, a plot of collector current, I_{C}, versus V_{BE} results in a series of peaks corresponding to the discrete energy levels of the quantum well. Over a portion of the interval between the current peaks, I_{C} decreases with V_{BE}, and thus the RTBT exhibits negative differential resistance (NDR). The degree of NDR is conventionally defined in terms of the peak-to-valley ratio (PVR) in I_{C}.

An RTBT with the quantum well barrier between the base and the collector is disclosed by Berthold et al., Applied Physics Letters, vol. 54, no. 9, February 1989, pages 813-815.

As is now known, connecting an RTBT to a load resistor results in a device which exhibits two (or more) stable electrical states. That is, when the load line associated with the load resistor is superimposed upon the plot of I_{C} versus V_{BE}, the two (or more) intersections of the former with the latter, where the latter has a positive slope, define the two (or more) stable states of the device. Consequently, the combination of an RTBT and a load resistor is capable of serving as a single-transistor logic and/or memory circuit.

For many applications, there is a need to achieve bistability in the absence of a load resistor. Thus, those engaged in the development of single-transistor devices have sought devices which can exhibit bistability in the absence of a load resistor.

### Summary of the Invention

The invention as set out in claim 1 involves a bipolar transistor which can exhibit bistability in the absence of an external load resistor.

The inventive, bistable bipolar transistor is distinguished from, for example, the above-described RTBTs in that the flow of current from emitter to collector is controlled, and bistability is achieved, not by controlling the emission process, but rather by controlling the collection process. That is, the inventive bipolar transistor includes a first potential barrier within the collector at, or adjacent to, the base-collector interface which is introduced by, for example, employing a relatively small bandgap semiconductor material in the base and a relatively large bandgap semiconductor material in the collector. To have a significant effect on current flow, the height of this first potential barrier, at room temperature (i.e., 23°C) and in the absence of applied voltages, should be equal to or greater than 1.5 kT, where k denotes Bolzmann's constant and T denotes absolute temperature. Significantly, and by contrast with previous bipolar transistors, the collector of the inventive bipolar transistor also includes at least a second potential barrier, having a height (at room temperature and in the absence of applied voltages) which is also equal to or greater than 1.5 kT. All barrier heights are expressed relative to the corresponding band edge. If the transistor is npn, the relevant band edge is the conduction band edge, and if pnp, the valence band edge.

Preferably, the inventive bipolar transistor includes at least a third potential barrier with a quantum well sandwiched between the second and third barriers. An embodiment containing forty such quantum wells interleaved between potential barriers has exhibited a PVR in I_{C} of 15 at room temperature, which is the highest such PVR ever reported.

### Brief Description of the Drawing(s)

The invention is described with reference to the accompanying drawings, wherein:
FIGs. 1 and 2 depict band diagrams corresponding to embodiments of the inventive bipolar transistor;
FIG. 3 depicts the hysteresis associated with an exemplary embodiment of the inventive transistor, which is typical of all the embodiments encompassed by the invention;
FIG. 4 is a cross-sectional view of the exemplary embodiment, referred to above;
FIG. 5 is a circuit-diagram representation of an optoelectronic circuit which includes both the inventive bipolar transistor and either a semiconductor laser diode or a light emitting diode, the former serving to drive the latter; and
FIG. 6 is a circuit-diagram representation of the optoelectronic circuit of FIG. 5, in which the voltage between the base and emitter of the inventive bipolar transistor is applied optically by an optical source, such as a semiconductor laser or a light emitting diode, in optical communication with the inventive transistor.

### Detailed Description

The invention is defined by the claims. In currently preferred embodiments, the invention encompasses electronic circuits and optoelectronic circuits, each of which includes at least one bipolar transistor. Significantly, this bipolar transistor exhibits bistability in the absence of a load resistor.

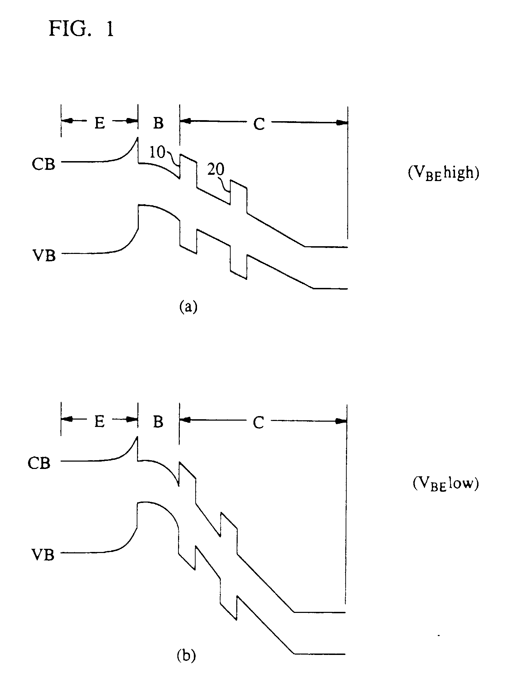

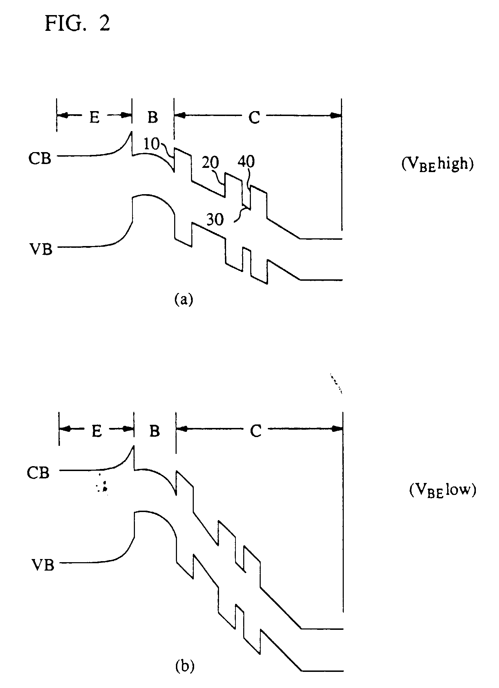

The bipolar transistor employed in the inventive circuits is similar to previous bipolar transistors in that it comprises an emitter, a base and a collector. In addition, the emitter includes a first semiconductor region, the base includes a second semiconductor region and the collector includes a third semiconductor region, the conductivity type of the first semiconductor region being the same as that of the third semiconductor region but opposite that of the second semiconductor region, e.g., the first and third semiconductor regions are n-type and the second semiconductor region is p-type, or vice versa. However, there are typically also significant differences between the inventive exemplary bipolar transistor and the previous bipolar transistors. These differences are conveniently described by reference to band diagrams, the corresponding physical structures being obvious to one of ordinary skill in the art. In this regard, FIGs. 1 and 2 depict the band diagrams corresponding to two embodiments of said bipolar transistor. In these figures, E, B and C denote the emitter, the base and the collector regions, respectively, of the inventive transistor. In addition, CB and VB denote the corresponding conduction and valence bands.

With reference to FIG. 1(a), the band diagram corresponding to a first embodiment of the transistor includes features common to all the embodiments. As shown, this first band diagram includes a potential barrier 10 within the collector at, or adjacent to, the base-collector interface. (Although the band diagram also depicts a potential barrier at the emitter-base interface, this is not essential to the invention.) As is known to those skilled in the art, such a potential barrier 10 is introduced by, for example, employing a relatively small bandgap semiconductor material in the base and a relatively large bandgap semiconductor material in the collector. To have a significant effect on current flow from base to collector, i.e., on collector current, I_{C}, the potential barrier height, at room temperature and in the absence of applied voltages, should be equal to or greater than 1.5 kT, and preferably equal to or greater than about 5 kT.

Significantly, I_{C} is controlled, and bistability is achieved, by indirectly controlling the height of the potential barrier 10. That is, as is common to all the embodiments, the band diagram depicted in FIG. 1 also includes a second potential barrier 20 within the collector. As is known, such a second potential barrier is introduced by, for example, altering the composition and/or doping level of the semiconductor material in the collector. The purpose of this second potential barrier is to produce an accumulation of electrical charges within the collector, in front of the second barrier, within the potential well existing between the barriers 10 and 20. To achieve a significant accumulation of electrical charges, the height of the potential barrier 20, at room temperature and in the absence of applied voltages, should also be equal to or greater than 1.5 kT, and preferably equal to or greater than about 5 kT.

In the operation of the transistor corresponding to the band diagram depicted in FIG. 1, the base-emitter junction is forward-biased while the collector-base junction is reverse-biased. (Consequently, if the transistor is an n-p-n transistor, the collector is biased positively relative to the emitter, while if the transistor is a p-n-p transistor, the collector is biased negatively relative to the emitter.) If the collector-emitter voltage, V_{CE}, is fixed, then the sum of the base-emitter voltage, V_{BE}, and collector-base voltage, V_{CB}, is also fixed and equal to V_{CE}. If the applied V_{BE} is relatively high (the meaning of which is discussed below) V_{CB} is necessarily relatively low. Under these circumstances (see FIG. 1(a)), the height of the potential barrier 20 is sufficient to preclude any significant discharge of the accumulated electrical charges, i.e., any significant flow of electrical charges across the potential barrier 20. Moreover, most of the potential drop across the collector occurs between the potential barrier 20 and the collector contact. On the other hand, if the applied V_{BE} is relatively low (the meaning of which is also discussed below), then V_{CB} is necessarily correspondingly high. Significantly, a relatively high V_{CB} serves to reduce the height of the second potential barrier (see FIG. 1(b)), which results in at least a partial discharge of the accumulated electrical charges. This permits the collector-base voltage to be felt across the entire width of the collector, including the region between the potential barriers, which results in a lowering of the potential barrier 10, and a significant increase in the flow of electrical charges from the base to the collector, i.e., a significant increase in I_{C}. Thus, by appropriately varying V_{BE} and, indirectly, V_{CB}, the inventive bipolar transistor is switched from a low conductivity state (low I_{C}) to a high conductivity state (high I_{C}).

With reference to FIG. 2(a), the band diagram corresponding to a second embodiment of the inventive transistor includes the potential barriers 10 and 20 within the collector, as in the first embodiment. In addition, there is also a third potential barrier 40 within the collector, adjacent the potential barrier 20, with a quantum well 30 between the barriers 20 and 40. As is known, the quantum well 30 is introduced by sandwiching a relatively thin layer of relatively small bandgap semiconductor material between layers of relatively large bandgap semiconductor material corresponding to the potential barriers 20 and 40. (To achieve significant quantum size effects, the thickness of the corresponding quantum well layer is preferably equal to or less than about 0.03 micrometers (µm).) As before, the height of each of the potential barriers 10, 20 and 40, at room temperature and in the absence of applied voltages, should be equal to or greater than 1.5 kT, and preferably equal to or greater than about 5 kT.

The presence of the two potential barriers 20 and 40 (like the presence of the potential barrier 20 in the first embodiment) results in the accumulation of electrical charges within the collector, in front of the two barriers. If V_{BE} is relatively high and V_{CB} is relatively low, then the potential barriers 20 and 40 are sufficiently high (see FIG. 2(a)) to preclude any significant discharge of the accumulated electrical charges. On the other hand, if V_{BE} is relatively low and V_{CB} is relatively high (see FIG. 2(b)), then the Fermi level of the accumulated charges is readily aligned with an energy eigenstate of the quantum well 40 and the accumulated charges are at least partially discharged via resonant tunneling across the potential barriers 20 and 40. This discharge results in a lowering of the potential barrier 10 and a corresponding increase in I_{C}.

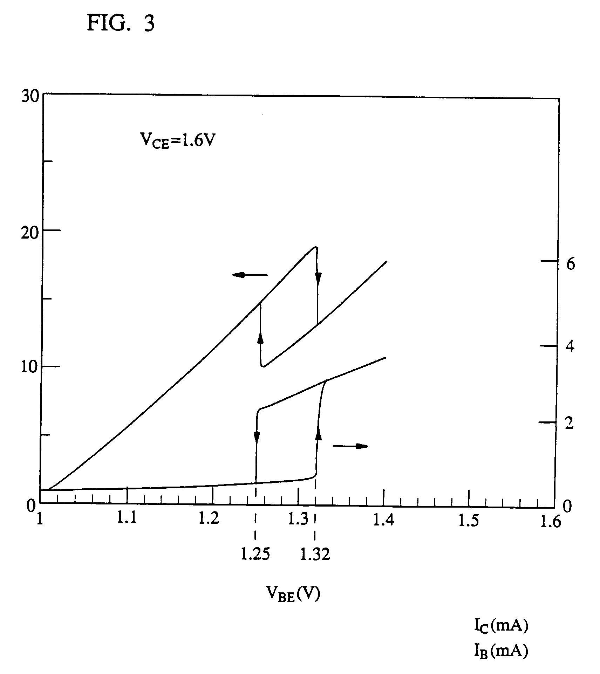

Significantly, by virtue of the presence of the accumulated electrical charges in the collector, discussed above, the inventive transistor can exhibit hysteresis. This hysteretic behavior is exemplarily depicted in FIG. 3, which includes measured plots of I_{C} versus V_{BE}, as well as I_{B} (base current) versus V_{BE}, for an exemplary embodiment of the inventive transistor, discussed below, corresponding to the band diagram of FIG. 2. It is by virtue of the hysteresis that bistability is achieved. That is, for the exemplary embodiment considered here, if V_{CE} is fixed and equal to, for example, 1.6 volts (V), and if V_{BE} is initially greater than about 1.32 V, then reducing V_{BE} results in I_{C} following the lower trajectory in the plot of I_{C} versus V_{BE}. At V_{BE} equal to about 1.25 V, the conductivity of the transistor, i.e., I_{C}, suddenly increases, due to the discharge of the accumulated charges. If V_{BE} is then increased, I_{C} follows the upper trajectory in the plot of I_{C} versus V_{BE}. At V_{BE} equal to about 1.32 V, the conductivity of the transistor suddenly decreases, due to a sufficient accumulation of electrical charges. Thus, if V_{BE} is initially greater than 1.32 V, reducing V_{BE} to a value equal to about 1.25 V (the relatively low voltage, referred to above) results in a switch to a relatively high conductivity state. On the other hand, increasing V_{BE} to a value equal to about 1.32 V (the relatively high voltage, referred to above) results in a switch to a relatively low conductivity state.

It should be noted that the plot of I_{B} versus V_{BE}, shown in FIG. 3, also exhibits hysteresis, as is the case with all embodiments of the inventive transistor. Moreover, when I_{C} suddenly increases from a relatively low value to a relatively high value, I_{B} does the reverse, and vice versa.

In general, in the operation of any embodiment of the inventive transistor, the voltage range over which hysteresis occurs is initially determined. Once this voltage range is known, bistable operation is readily achieved by an appropriate choice of relatively low and relatively high voltages.

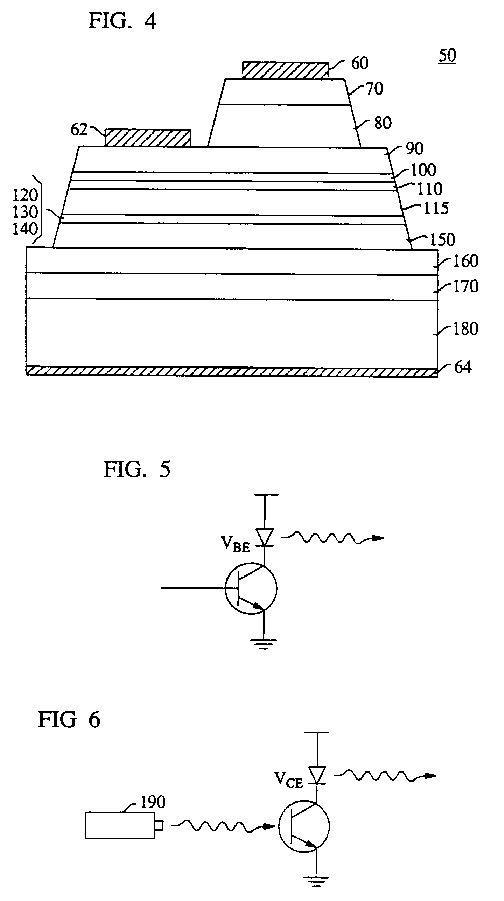

The exemplary embodiment of the inventive transistor, referred to above, having the band diagram of FIG. 2, is an n-p-n type transistor, and is depicted in FIG. 4. As shown, this embodiment 50 includes an n-type layer 80 of InP, which serves as the emitter. The thickness of the layer 80 is, for example, 0.3 micrometers (µm), while the concentration of n-type dopant within this layer is, for example, 5x10¹⁷cm⁻³. Good electrical contact to the emitter 80 is achieved by providing an overlying contact layer 70 of n⁺-type In_{.53}Ga_{.47}As having a thickness of, for example, 0.2 µm and a dopant concentration of, for example, 2x10¹⁹cm-³.

The base of the exemplary embodiment 50 includes a p-type layer 90 of In_{.53}Ga_{.47}As. Preferably, adjacent and contiguous with the p-type layer 90 there is an n⁻-type setback layer 100 of In_{.53}Ga_{.47}As. The former has a thickness of, for example, 0.15 µm and a corresponding dopant concentration of, for example, 2x10¹⁸cm⁻³. The latter has a thickness of, for example, 0.05 µm and a corresponding dopant concentration of, for example, 3x10¹⁶cm⁻³.

The collector includes an n⁻-type layer 110 of InP, which forms a heterojunction with the base, the presence of the layer 110 resulting in the potential barrier 10 depicted in FIG. 2. The thickness of the layer 110 is, for example, 0.05 µm, while the corresponding doping level is, for example, 3x10¹⁶cm⁻³. The collector also includes a layer 115 of intrinsic In_{.53}Ga_{.47}As, As, in which charges (in this case, electrons) accumulate, as discussed above. The thickness of the layer 115 is, for example, 0.1 µm.

Significantly, the collector further includes two potential barrier layers 120 and 140 of intrinsic InP separated by a quantum well layer 130 of intrinsic In_{.53}Ga_{.57}As, corresponding to the potential barriers 20 and 40 and quantum well 30 of FIG. 2. The thicknesses of each of these layers is, for example, 0.01 µm. In addition, the collector includes a layer 150 of intrinsic In_{.57}Ga_{.43}As and a layer 160 of n⁺-type In_{.53}Ga_{.43}As. The thickness of the layer 150 is, for example 0.1 µm, while the thickness of the layer 160 is, for example, 0.2 µm. The dopant concentration within the layer 160 is, for example, 2x10¹⁹cm⁻³.

All of the above-described layers are readily grown on an n⁺-type InP substrate 180, the dopant concentration within the substrate being, for example, 2x10¹⁸cm⁻³. Preferably, to achieve good epitaxial growth of the various layers, a buffer layer 170 of n⁺-type InP is initially grown on the substrate 180, the above-described layers being grown on the buffer layer. The thickness of the buffer layer 170 is, for example, 0.2 µm, while the corresponding dopant concentration is, for example, 5x10¹⁸cm⁻³.

The various layers of the embodiment 50 are readily grown using conventional techniques such as metal-organic chemical vapor deposition (MOCVD), molecular beam epitaxy (MBE) and chemical beam epitaxy (CBE) techniques.

Electrical isolation between the emitter and base of the embodiment 50 is conveniently achieved by etching the various layers of the embodiment to form two mesas. As depicted in FIG.4, the first such mesa includes the (etched) layers 70 and 80, and thus includes the emitter, while the second mesa includes the (etched) layers 90-150, and thus includes the base. The upper surfaces of the first and second mesas have areas of, for example, 2.5x10⁻⁵cm² and 1.9x10⁻⁴cm², respectively. Electrical contacts 60 and 62 to the emitter and base, respectively, are readily formed on the mesas. The electrical contact 60 includes, for example, successive layers of Ni, Ge, Au, Ag and Au, while the electrical contact 62 includes, for example, successive layers of AuBe, Ti and Au. An electrical contact to the collector is conveniently formed on the backside of the substrate 180 and includes, for example, successive layers of Ni, Ge, Au, Ag and Au.

The exemplary embodiment 50, described above, includes but a single quantum well layer 130 sandwiched between potential barrier layers 120 and 140. It must be emphasized that the invention also encompasses embodiments in which the collector includes two or more quantum well layers, interleaved between potential barrier layers. In fact, in addition to fabricating the exemplary embodiment 50, an embodiment containing forty such quantum well layers interleaved between potential barrier layers has also been fabricated. Significantly, the embodiment containing the forty quantum wells has exhibited a PVR in I_{C} of 15 at room temperature, which is the highest ever reported.

While the exemplary embodiment 50 was formed using the InP/InGaAs material system, this same embodiment, as well as the other embodiments encompassed by the invention, are also readily fabricated in other material systems including, for example, InP/InAlGaAs, GaAs/AlGaAs and Si/SiGe.

The bistability exhibited by the inventive bipolar transistor makes it well suited for use in a variety of electronic circuits including, for example, single-transistor electronic memory circuits and electronic logic circuits. In addition, the bistability exhibited by the inventive bipolar transistor makes it well suited for use in a variety of optoelectronic circuits. For example, the inventive bipolar transistor can be useful as a single-transistor driver circuit for electrically driving a semiconductor laser diode or a light emitting diode. The corresponding circuit diagram is shown in FIG. 5. Such a laser or light emitting diode is readily physically integrated with, for example, the embodiment 50 (see FIG. 4) by growing the material layers associated with the diode on the buffer layer 170, beneath the material layers associated with the transistor.

Rather than electrically altering the V_{BE} applied to the base of the bipolar transistor, and thereby driving a laser diode or light emitting diode, the same thing is also readily accomplished optically. That is, by impinging the inventive transistor with light which is absorbed by, for example, the base, V_{BE} is readily altered as depicted in FIG. 6. Thus, when placed in optical communication with an appropriate optical source 190, such as a semiconductor laser or light emitting diode, the transistor/diode combination can usefully serve as an optical repeater (regenerator).

## Claims

1. A semiconductor circuit, comprising at least one bipolar transistor comprising an emitter region (70, 80), a base region (90), and a collector region (110, 115, 120, 130, 140, 150, 160), and respective electrical contacts thereto (60, 62, 64) wherein:
a) the emitter region includes a first semiconductor region (80) of a first conductivity type, having carriers of a first type as majority carriers;
b) the base region is positioned between the emitter region and the collector region and includes a second semiconductor region (90) of a second conductivity type opposite to the first conductivity type;
c) the collector region includes third (110) and fourth (120, 130, 140) semiconductor regions and, between the third and fourth regions, at least a fifth semiconductor region (115), the third region being nearer to the base region;
d) the collector region is capable of receiving electrical charges emitted by the emitter and transported across the base;
e) the third region has a band edge for said carriers of a first type which, at room temperature and in the absence of applied voltages, corresponds to an energy of said carriers of a first type at least 1.5 kT greater than the band edges of the second and fifth regions where T is the absolute temperature and k is Boltzmann's constant, whereby the third region constitutes a potential barrier (10) to the flow of said carriers of a first type from the base region into the collector region; and
f) the fourth region includes a further region (120) adjoining said fifth region and having a band edge for said carriers of a first type which, at room temperature and in the absence of applied voltages, corresponds to an energy of said carriers of a first type of at least 1.5 kT greater than the band edge of the fifth region, whereby the fourth region constitutes a potential barrier (20, 40) to the flow of said carriers of a first type across the collector region;
wherein
the third region is of the first conductivity type; and
the third, fourth, and fifth regions are such that, with a constant voltage (V_{CE}) applied between the collector and emitter contacts,
while the voltage (V_{BE}) applied between the base and emitter contacts is greater than a higher operating value, the potential barrier of the fourth region prevents the flow of said carriers of a first type across the collector region whereby the carriers of the first type are accumulated in the fifth region, thereby defining a charged state of the fifth region, in which state the potential barrier of the third region prevents the flow of said carriers of a first type from said base region into said collector region,
the fifth region can be maintained in said charged state while the voltage (V_{BE}) applied between the base and emitter contacts is greater than a lower operating value,
while the voltage (V_{BE}) applied between the base and emitter contacts is less than a lower operating value, the potential barrier of the fourth region is reduced such that carriers of a first type flow across the collector region, thereby defining an at least partially discharged state of the fifth region, whereby the height of the potential barrier of the third region is reduced such that carriers of a first type flow from said base region into said collector region,
the fifth region can be maintained in said at least partially discharged state while the voltage (V_{BE}) applied between the base and emitter contacts is less than said higher operating value,
whereby the transistor has a bistable operating characteristic for values of the voltage (V_{BE}) applied between the base and emitter contacts between the said higher and lower operating values.

2. A circuit as claimed in claim 1 wherein the fourth semiconductor region is a resonant tunneling structure comprising a pair of barrier regions (120, 140) of comparatively large bandgap separated by a thin layer (130) of comparatively small bandgap, said barrier regions having a band edge for said carriers of a first type which, at room temperature and in the absence of applied voltages, corresponds to an energy of said carriers of a first type of at least 1.5 kT greater than the band edge of the fifth region, one of said barrier regions being said further region (120) and the other barrier region constituting a potential barrier (40) to the flow of said carriers of a first type across the collector region.

3. A circuit as claimed in any one of claim 1 or claim 2 including a thin lightly doped setback layer (100) of the first conductivity type between and contiguous with the base region and the third region.

## Patentansprüche

1. Halbleiterschaltung mit mindestens einem Bipolartransistor mit einem Emitterbereich (70, 80), einem Basisbereich (90) und einem Kollektorbereich (110, 115, 120, 130, 140, 150, 160) und mit diesen verbundenen entsprechenden elektrischen Kontakten (60, 62, 64), wobei:
a) der Emitterbereich einen ersten Halbleiterbereich (80) eines ersten Leitfähigkeitstyps mit Trägern eines ersten Typs als Majoritätsträger enthält;
b) der Basisbereich zwischen dem Emitterbereich und dem Kollektorbereich angeordnet ist und einen zweiten Halbleiterbereich (90) eines zweiten, dem ersten Leitfähigkeitstyp entgegengesetzten Leitfähigkeitstyps enthält;
c) der Kollektorbereich dritte (110) und vierte (120, 130, 140) Halbleiterbereiche und zwischen den dritten und vierten Bereichen mindestens einen fünften Halbleiterbereich (115) enthält, wobei der dritte Bereich näher an dem Basisbereich liegt;
d) der Kollektorbereich in der Lage ist, elektrische Ladungen aufzunehmen, die durch den Emitter emittiert und über die Basis hinweg transportiert werden;
e) der dritte Bereich eine Bandkante für die besagten Träger eines ersten Typs aufweist, die bei Zimmertemperatur und bei Abwesenheit angelegter Spannungen einer Energie der besagten Träger eines ersten Typs entspricht, die mindestens 1,5 kT größer als die Bandkanten des zweiten und fünften Bereichs ist, wobei T die absolute Temperatur und k die Boltzmann-Konstante ist, wodurch der dritte Bereich eine Potentialschwelle (10) für den Fluß der besagten Träger eines ersten Typs aus dem Basisbereich in den Kollektorbereich darstellt; und
f) der vierte Bereich einen weiteren Bereich (120) enthält, der an den besagten fünften Bereich angrenzt und eine Bandkante für die besagten Träger eines ersten Typs aufweist, die bei Zimmertemperatur und bei Abwesenheit angelegter Spannungen einer Energie der besagten Träger eines ersten Typs entspricht, die mindestens 1,5 kT größer als die Bandkante des fünften Bereichs ist, wodurch der vierte Bereich eine Potentialschwelle (20, 40) für den Fluß der besagten Träger eines ersten Typs über den Kollektorbereich darstellt;
wobei
der dritte Bereich von dem ersten Leitfähigkeitstyp ist; und
die dritten, vierten und fünften Bereiche dergestalt sind, daß bei einer konstanten Spannung (V_{CE}), die zwischen den Kollektor- und Emitterkontakten angelegt wird,
während die zwischen den Basis- und Emitterkontakten angelegte Spannung (V_{BE}) größer als ein höherer Betriebswert ist, die Potentialschwelle des vierten Bereichs den Fluß der besagten Träger eines ersten Typs über den Kollektorbereich verhindert, wodurch die Träger des ersten Typs in dem fünften Bereich akkumuliert werden und dadurch einen geladenen Zustand des fünften Bereichs definieren, wodurch die Potentialschwelle des dritten Bereichs den Fluß der besagten Träger eines ersten Typs aus dem besagten Basisbereich in den besagten Kollektorbereich verhindert,
der fünfte Bereich in dem besagten geladenen Zustand gehalten werden kann, während die zwischen den Basis- und Emitterkontakten angelegte Spannung (V_{BE}) größer als ein niedrigerer Betriebswert ist,
während die zwischen den Basis- und Emitterkontakten angelegte Spannung (V_{BE}) kleiner als ein niedrigerer Betriebswert ist, die Potentialschwelle des vierten Bereichs verringert ist, so daß Träger eines ersten Typs über den Kollektorbereich fließen und dadurch einen mindestens teilweise entladenen Zustand des fünften Bereichs definieren, wodurch die Höhe der Potentialschwelle des dritten Bereichs verringert wird, so daß Träger eines ersten Typs aus dem besagten Basisbereich in den besagten Kollektorbereich fließen,
der fünfte Bereich in dem besagten mindestens teilweise entladenen Zustand gehalten werden kann, während die zwischen den Basis- und Emitterkontakten angelegte Spannung (V_{BE}) kleiner als der besagte höhere Betriebswert ist,
wodurch der Transistor für Werte der zwischen den Basis- und Emitterkontakten angelegten Spannung (V_{BE}), die zwischen den besagten höheren und niedrigeren Betriebswerten liegen, ein bistabiles Betriebsverhalten aufweist.

2. Schaltung nach Anspruch 1, wobei der vierte Halbleiterbereich eine Struktur mit Resonanztunneleffekt ist, die ein Paar Sperrbereiche (120, 140) mit vergleichsweise großer Bandlücke umfaßt, die durch eine dünne Schicht (130) mit vergleichsweise kleiner Bandlücke getrennt werden, wobei die besagten Sperrbereiche eine Bandkante für die besagten Träger eines ersten Typs aufweisen, die bei Zimmertemperatur und bei Abwesenheit angelegter Spannungen einer Energie der besagten Träger eines ersten Typs entspricht, die mindestens 1,5 kT größer als die Bandkante des fünften Bereichs ist, wobei einer der besagten Sperrbereiche der besagte weitere Bereich (120) ist und der andere Sperrbereich eine Potentialschwelle (40) für den Fluß der besagten Träger eines ersten Typs über den Kollektorbereich darstellt.

3. Schaltung nach Anspruch 1 oder 2, einschließlich einer zwischen dem Basisbereich und dem dritten Bereich liegenden und an diese anschließenden dünnen, schwach dotierten Rückstellschicht (100) des ersten Leitfähigkeitstyps.

## Revendications

1. Circuit semi-conducteur, comprenant au moins un transistor bipolaire comprenant une région d'émetteur (70, 80), une région de base (90), et une région de collecteur (110, 115, 120, 130, 140, 150, 160), et des contacts électriques respectifs avec celles-ci (60, 62, 64) dans lequel :
a) la région d'émetteur comporte une première région semi-conductrice (80) d'un premier type de conductivité, ayant des porteurs d'un premier type comme porteurs majoritaires ;
b) la région de base est positionnée entre la région d'émetteur et la région de collecteur et comporte une deuxième région semi-conductrice (90) d'un deuxième type de conductivité opposé au premier type de conductivité ;
c) la région de collecteur comporte des troisième (110) et quatrième (120, 130, 140) régions semi-conductrices et, entre les troisième et quatrième régions, au moins une cinquième région semi-conductrice (115), la troisième région étant plus proche de la région de base ;
d) la région de collecteur est capable de recevoir des charges électriques émises par l'émetteur et transportées à travers la base ;
e) la troisième région a un bord de bande pour lesdits porteurs d'un premier type qui, à température ambiante et en l'absence de tensions appliquées, correspond à une énergie desdits porteurs d'un premier type au moins 1,5 kT supérieure aux bords de bande des deuxième et cinquième régions où T est la température absolue et k est la constante de Boltzmann, si bien que la troisième région constitue une barrière de potentiel (10) au flux desdits porteurs d'un premier type depuis la région de base dans la région de collecteur ; et
f) la quatrième région comporte une autre région (120) attenante à ladite cinquième région et ayant un bord de bande pour lesdits porteurs d'un premier type qui, à température ambiante et en l'absence de tensions appliquées, correspond à une énergie desdits porteurs d'un premier type d'au moins 1,5 kT supérieure au bord de bande de la cinquième région, si bien que la quatrième région constitue une barrière de potentiel (20, 40) au flux desdits porteurs d'un premier type à travers la région de collecteur ;
dans lequel
la troisième région est du premier type de conductivité ; et
les troisième, quatrième et cinquième régions sont telles que, avec une tension constante (V_{CE}) appliquée entre les contacts de collecteur et d'émetteur,
tant que la tension (V_{BE}) appliquée entre les contacts de base et d'émetteur est supérieure à une valeur opérationnelle supérieure, la barrière de potentiel de la quatrième région empêche le flux desdits porteurs d'un premier type à travers la région de collecteur si bien que les porteurs du premier type s'accumulent dans la cinquième région, définissant ainsi un état chargé de la cinquième région, dans lequel état la barrière de potentiel de la troisième région empêche le flux desdits porteurs d'un premier type depuis la région de base dans ladite région de collecteur,
la cinquième région peut être maintenue dans ledit état de charge tant que la tension (V_{BE}) appliquée entre les contacts de base et d'émetteur est supérieure à une valeur opérationnelle inférieure,
tant que la tension (V_{BE}) appliquée entre les contacts de base et d'émetteur est inférieure à une valeur opérationnelle inférieure, la barrière de potentiel de la quatrième région est réduite de telle sorte que les porteurs d'un premier type traversent la région de collecteur, définissant ainsi un état au moins partiellement déchargé, si bien que la hauteur de la barrière de potentiel de la troisième région est réduite de telle sorte que les porteurs d'un premier type passent depuis ladite région de base dans ladite région de collecteur,
la cinquième région peut être maintenue dans ledit état au moins partiellement déchargé tant que la tension (V_{BE}) appliquée entre les contacts de base et d'émetteur est inférieure à ladite valeur opérationnelle supérieure,
si bien que le transistor a une caractéristique opérationnelle bistable pour des valeurs de la tension (V_{BE}) appliquée entre les contacts de base et d'émetteur comprises entre lesdites valeurs opérationnelles supérieure et inférieure.

2. Circuit selon la revendication 1, dans lequel la quatrième région semi-conductrice est une structure de passage par effet tunnel résonnante comprenant une paire de régions d'arrêt (120, 140) d'une bande interdite comparativement grande séparées par une fine couche (130) d'une bande interdite comparativement petite, lesdites régions d'arrêt ayant un bord de bande pour lesdits porteurs d'un premier type qui, à température ambiante et en l'absence de tensions appliquées, correspond à une énergie desdits porteurs d'un premier type d'au moins 1,5 kT supérieure au bord de bande de la cinquième région, l'une desdites régions d'arrêt étant ladite autre région (120) et l'autre région d'arrêt constituant une barrière de potentiel (40) au flux desdits porteurs d'un premier type à travers la région de collecteur.

3. Circuit selon la revendication 1 ou la revendication 2, comportant une fine couche en retrait légèrement dopée (100) du premier type de conductivité entre et contiguë à la région de base et la troisième région.
